# EUROPEAN PATENT APPLICATION

(11) **EP 1 840 054 A1**
(43) Date of publication of application: **03.10.2007**
(21) Application number: 05816584.6
(22) Date of filing: 12.12.2005
(51) Int. Cl.: B65G 49/06, H01L 21/00

(54) **BOARD MATERIAL STORING METHOD AND APPARATUS**

(30) Priority: 13.12.2004 JP 2004360186
(71) Applicant: Corning Japan K.K., 1-11-44, Akasaka, Minato-ku Tokyo 107-0052 (JP); Ishikawajima-Harima Heavy Industries Co., Ltd., Chiyoda-ku, Tokyo 100-8182 (JP)
(72) Inventor: SHINKAI, Masayuki, Kakegawa-shi, Shizuoka 437-1397 (JP); Sugiyama, Susumu, Kakegawa-shi, Shizuoka 437-1397 (JP); Ishibashi, M., Ishikawajima-Harima Heavy Ind Co., Chiyoda-ku, Tokyo 100-8182 (JP); Ono, T., Ishikawajima-Harima Heavy Ind. Co., Ltd., Chiyoda-ku, Tokyo 100-8182 (JP); Wada, Y., Ishikawajima-Harima Heavy Ind. Co., Ltd, Chiyoda-ku, Tokyo 100-8182 (JP); Tokuda, Taro, Ishikawajima-Harima Heavy Ind Co Ltd, Chiyoda-ku, Tokyo 100-8182 (JP)
(74) Representative: Klunker, Hans-Friedrich
(86) International application number: PCT/JP2005/023191
(87) International publication number: WO 2006/064925

(57) **Abstract**

A device for storing plates in a case one by one without scratching or staining the plates and within a short cycle time is disclosed. A conveyance means 20 for conveying a plate 10 held upright to a taking-out position and case holding means 13, 25 for holding a case 1 below the taking-out position are provided. Further, a plate transfer means is formed by glass-inserting hands 22 and other components. The glass-inserting hands 22 include receiving members 39 for receiving the lower end of the plate 10. The glass-inserting hands 22 hold the plate 10, positioned at the taking-out position, on the receiving members 39, and moves the plate 10 down from the taking-out position to place it in one of grooves provided in the case 1. The plate 10 is held upright without contacted thereto by plate holding means 23 that blows air against opposite surfaces of the plate at least while the plate 10 is moved out from the taking-out position and received in the groove of the case 1.

## Description

### Technical Field

The present invention relates to a method for storing plates, such as glass plates, in a case adapted to store the plates in the upright position by supplying the plates one by one to the case, and to an apparatus for carrying out the method.

### Background Art

For example, in a process for manufacturing plates such as glass plates, it has conventionally and widely been practiced to convey the plates held in an upright or substantially upright state (hereinafter referred to as the upright position), then store a predetermined number of plates in a predetermined case, and transfer each case to the subsequent process or a destination of delivery. An example of an apparatus for conveying plates in the upright position is shown in Japanese Unexamined Patent Publication No. 2002-308423.

Further, an example of the case as described above is a known type of case which has pairs of vertical grooves formed in the inner surfaces of the right and left side plates thereof, where each plate is stored in the upright position with the right and left end portions thereof received in one of the groove pairs. In order to store the plates in this type of case by supplying the plates one by one to the case, conventionally, the following method is often applied. The plates are held in the upright position and conveyed to a predetermined taking-out position by a conveyance means. The case is placed at the side and in the vicinity of the taking-out position. Each plate is stopped at the taking-out position, and the top and side edges of the plate are held by a robot hand. Then, the robot hand is pivoted to insert the plate into the case from above.

However, in the above-described conventional method for storing plates in a case using a robot hand, the robot hand contacts the plates, and therefore the plates may be scratched or stained. In particular, in a case where the plates are, for example, glass plates to be used in precision optical devices, the commercial value of the plates are significantly impaired if they have a slight scratch or stain.

Further, when the robot hand is pivoted to reciprocate between the taking-out position and the case, as described above, the reciprocating motion takes a certain time. Since there is a natural limit for speeding-up of the robot hand, it is difficult to reduce the cycle time.

In order to reduce the cycle time as possible, it is considered that, while the plates are stored in one case, another case to be used next is placed near the robot hand, so that the next case can be used immediately after a predetermined number of plates have been stored in the one case. However, this requires more space for placing the cases. In particular, in a case where the plates are inspected and classified into acceptable plates and defective plates to be stored in separate cases, there are a total of four cases and a very wide space is necessary for placing these cases.

The case containing the predetermined number of plates is conveyed to the next place for the subsequent process. A case conveyance means used for this purpose needs to be placed so as not to interfere with the robot hand. This also necessitates a wider space, and complicates a mechanism around the robot hand and the case conveyance means.

Furthermore, if accuracy of positioning the plate at the taking-out position or positional accuracy of the grooves formed in the case is insufficient, the plate held by the robot hand and being placed in the groove of the case may interfere with the case without being accurately inserted into the grooves and be damaged.

In view of the above-described circumstances, the present invention is directed to provide a method for storing plates that is capable of storing the plates in a case in a shorter cycle time using a simple mechanism, without scratching or staining the surfaces of the plate.

The present invention is further directed to provide an apparatus for storing plates that is capable of carrying out the above method. The present invention is still further directed to provide an apparatus for storing plates that is capable of carrying out the above method, and is also capable of preventing the plates from interfering with the case and being damaged.

### Disclosure of the Invention

The plate storing method of the present invention is a method for storing plates in a case by supplying the plates one by one to the case. The case has pairs of vertical grooves formed in inner surfaces of right and left side plates thereof, and the plates are stored in the case in the upright position with right and left end portions of each plate placed in one of the groove pairs. The method includes the steps of: conveying each plate held in the upright position to a predetermined taking-out position; placing the case below the taking-out position; receiving and holding a lower end face of the plate positioned at the taking-out position and moving the plate down from the taking-out position into one of the groove pairs of the case; and holding the plate in the upright position by blowing gas against opposite surfaces of the plate without contacting thereto at least while the plate is moved from the taking-out position and received in the groove pair of the case.

The plate storing apparatus of the invention is an apparatus for storing plates in a case by supplying the plates one by one to the case, the case having pairs of vertical grooves formed in inner surfaces of right and left side plates thereof, the plates being stored in the case in the upright position with right and left end portions of each plate placed in one of the groove pairs. The apparatus includes: conveyance means for conveying each plate held in the upright position to a predetermined taking-out position; case holding means for holding the case below the taking-out position; plate transfer means having receiving members for receiving a lower end face of the plate from below, the plate transfer means holding the plate positioned at the taking-out position on the receiving members and moving the plate down from the taking-out position into one of the groove pairs of the case; and plate holding means for holding the plate in the upright position by blowing gas against opposite surfaces of the plate without contacting thereto at least while the plate is moved from the taking-out position and received in the groove pair of the case.

Preferably, the plate storing apparatus of the invention may further include a sensor for detecting the position of the next one of the groove pairs of the case to receive the next plate, and means for finely adjusting the position of the case based on a groove position detection signal outputted by the sensor to set the next groove pair in a fixed relative position with respect to the plate transfer means.

Preferably, the plate storing apparatus of the invention may further include guide means for positioning right and left end faces of the plate being moved down by the plate transfermeans at a position above the next groove pair and guiding the right and left end portions of the plate toward the next groove pair.

Preferably, in the plate storing apparatus of the invention, the plate transfer means may be movable only in the vertical direction, and the conveyance means may be retracted sideways when the plate has been lifted by the receiving members of the moved-up plate transfer means and separated from the conveyance means, to avoid interference with the plate being moved down.

Preferably, in the plate storing apparatus of the invention, the plate transfer means may be movable only in the vertical direction, and each time one plate has been stored in the case, the case holding means may move the case, having the pairs of right and left grooves arranged at a predetermined pitch, by a distance approximately equal to the pitch in a direction of arrangement of the groove pairs to set the next groove pair for receiving the next plate in a fixed relative position with respect to the plate transfer means.

According to the plate storingmethod of the invention, each plate held in the upright position is conveyed to a predetermined taking-out position, a case is placed below the taking-out position, and the plate positioned at the taking-out position is received and held at a lower end face thereof and moved down from the taking-out position into one of the groove pairs of the case. The plate is held in the upright position by blowing gas against opposite surfaces of the plate without contacting thereto at least while the plate is moved from the taking-out position and received in the groove pair of the case. Therefore, the transfer means for transferring the plate from the taking-out position into the case essentially contacts only the lower end face of the plate. Therefore, the surfaces of the plate can be reliably prevented from being scratched or stained.

The plate storing apparatus of the invention includes the aforementioned plate conveyance means, as well as the case holding means, the plate transfer means and the plate holding means. Therefore, the plate storing apparatus is capable of carrying out the above-described plate storing method to store plates without making a scratch or stain on the surfaces of the plate.

Further, in the plate storing apparatus, the plate at the taking-out position is received by the plate transfer means, and the plate transfer means is moved down to put the plate in the case, which is placed below the taking-out position, from above. Therefore, the plate can be stored in the case in a shorter cycle time than conventional apparatuses in which the glass plate is moved sideways by a large amount to be put in the case by a pivoting robot hand.

In addition, since this plate storing apparatus does not move the glass plate sideways by a large amount to put it in the case, the mechanism thereof is simple and it is not necessary to position the case conveyance means or the next case so as not to interfere with such a robot hand that moves sideways. Therefore, the space required for placing the plate storing apparatus, and the associated case conveyance means and other components is relatively small.

In a case where the plate storing apparatus of the invention includes the sensor for detecting the position of the next groove pair of the case to receive the next plate, and the means for finely adjusting the position of the case based on the groove position detection signal outputted by the sensor to set the next groove pair in a fixed relative position with respect to the plate transfer means, the plate is always accurately received in the groove pair. Therefore, the plate can be reliably prevented from interfering with the case and being damaged.

Further, in a case where the plate storing apparatus of the invention includes the guide means for positioning right and left end faces of the plate being moved down by the plate transfermeans at a position above the next groove pair and guiding the right and left end portions of the plate toward the next groove pair, the plate is always accurately received in the groove pair. Therefore, the plate can be reliably prevented from interfering with the case and being damaged. Note that, even in the case where such guide means is provided, the guide means essentially contacts only the right and left end faces of the plate. Therefore, the surfaces of the plate can practically be prevented from being scratched or stained.

Furthermore, in the plate storing apparatus of the present invention, in a case where the plate transfer means is movable only in the vertical direction, and the conveyance is retracted sideways when the plate has been lifted by the receiving members of the moved-up plate transfer means and separated from the conveyance means, to avoid interference with the plate being moved down, the structure of the plate transfer means is simplified and therefore apparatus costs can be reduced.

Moreover, in the plate storing apparatus of the present invention, in a case where the plate transfer means is movable only in the vertical direction, and each time one plate has been stored in the case, the case holding means moves the case, having the pairs of right and left grooves arranged at a predetermined pitch, by a distance approximately equal to the pitch in a direction of arrangement of the groove pairs to set the next groove pair for receiving the next plate in a fixed relative position with respect to the plate transfer means, the structure of the plate transfer means is simplified and therefore apparatus costs can be reduced.

### Brief Description of the Drawings

FIG. 1 is a plan view of a plate storing apparatus according to an embodiment of the present invention,
FIG. 2 is a front view of the plate storing apparatus,
FIG. 3 is a side view of the plate storing apparatus,
FIG. 4 is an overall plan view of a plate storing system employing the plate storing apparatus,
FIG. 5 is a partially cut-awayperspective view showing a case handled by the plate storing apparatus,
FIG. 6 is a plan view showing a guide roller used in the plate storing apparatus, and
FIGS. 7A to 7F are explanatory diagrams for explaining operation of the plate storing apparatus.

### Best Mode for Carrying Out the Invention

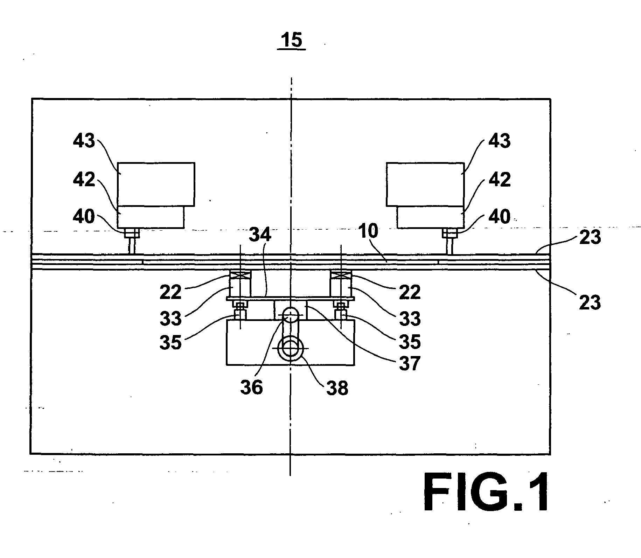

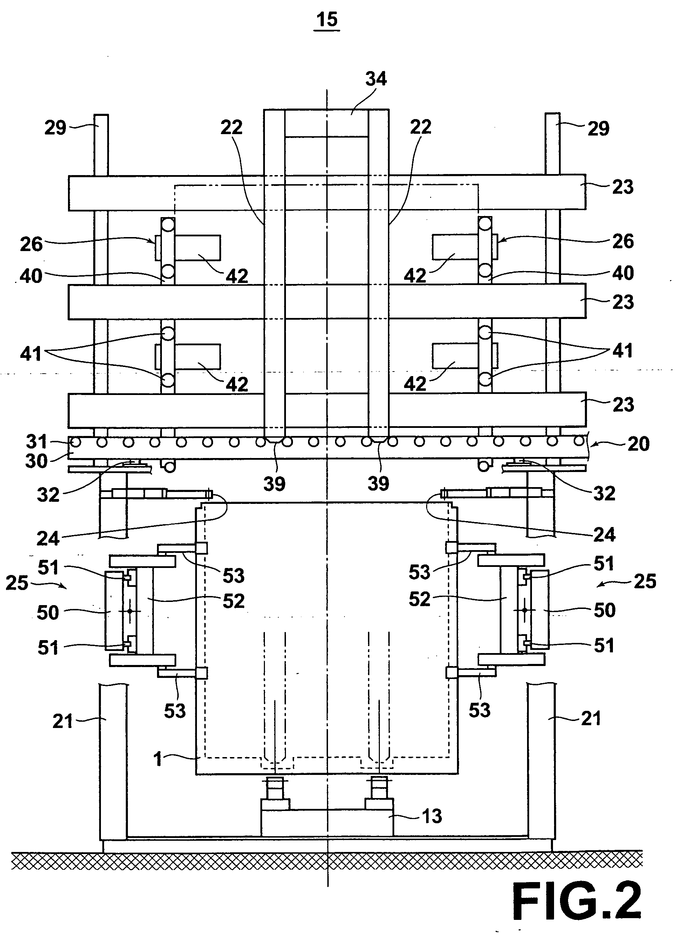

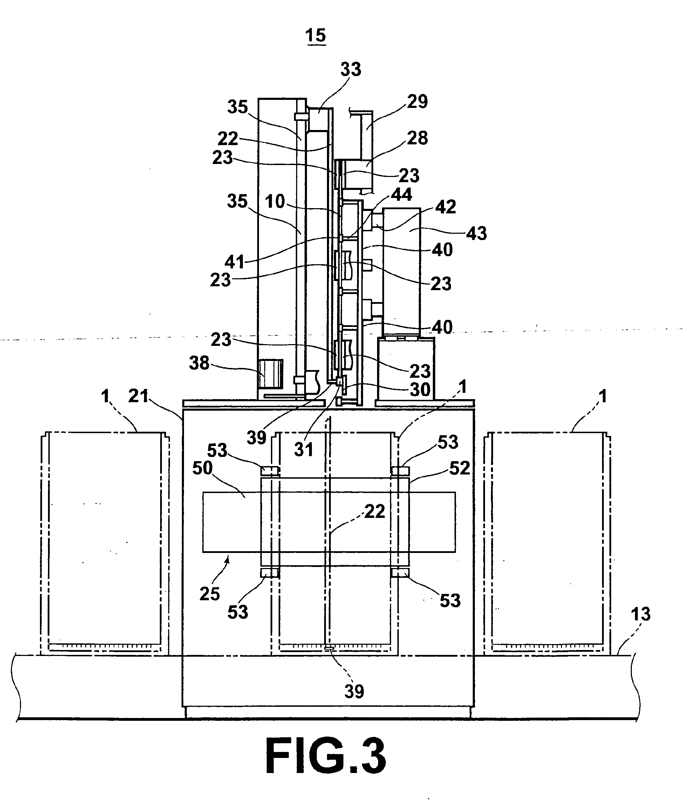

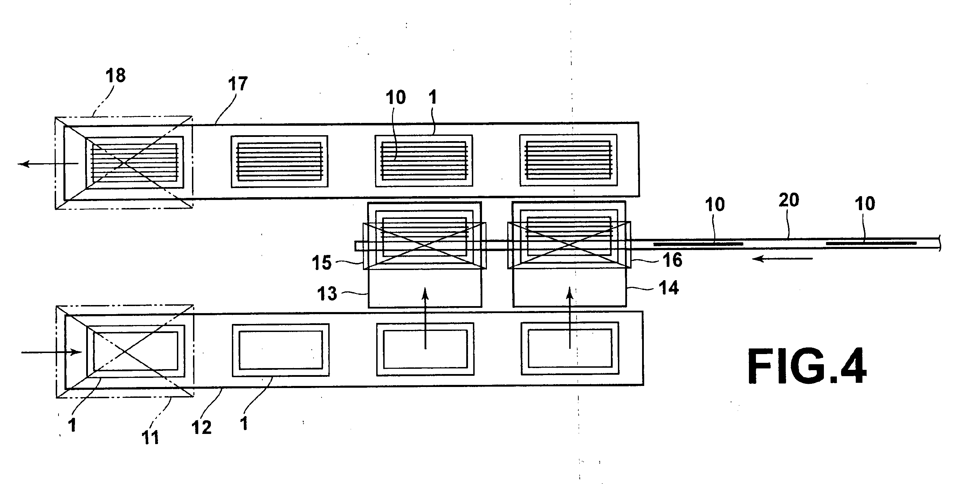

Hereinafter, an embodiment of the present invention will be described in detail with reference to the drawings. Figs. 1, 2 and 3 are a plan view, a front view and a side view of a plate storing apparatus according to the embodiment of the present invention, respectively. Fig. 4 is a plan view of a plate storing system including the plate storing apparatus. It should be noted that the front view of Fig. 2 corresponds to the plate storing apparatus in Fig. 4 viewed from below, and the side view of Fig. 3 corresponds to the same apparatus in Fig. 4 viewed from the right.

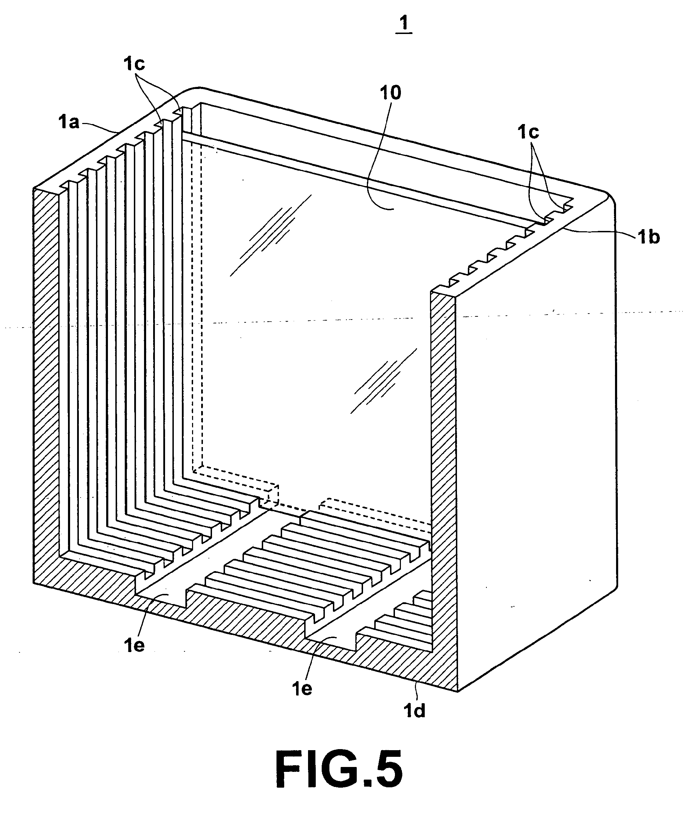

First, an overview of the plate storing system will be described with reference to Fig. 4. As an example, this system is configured to store glass plates 10, which are plates of the invention, in a polypropylene (PP) case 1 with an open top. The detailed configuration of the case 1 is shown in Fig. 5. As shown in the figure, the case 1 is formed in a box shape with the open top. The case 1 includes left and right side plates 1a and 1b, each having vertically-extending grooves 1c formed in the inner surface thereof. The glass plates 10 are stored in the case 1 with the right and left ends of each glass plate 10 received in one of the pairs of right and left grooves 1c and 1c. A bottom plate 1d of the case 1 has two grooves le formed in the inner surface thereof. The two grooves le extend in the direction in which the grooves 1c are arranged side by side to each other.

At a case supply station 11 shown in Fig. 4, the empty cases 1 are supplied one by one onto a case supply conveyor 12, which is formed, for example, by a roller conveyor. Each case 1 is conveyed to the right in Fig. 4 by the case supply conveyor 12. Then, each case 1 is transferred by a means (not shown) onto a case cross-feed conveyor 13 or 14, each formed, for example, by a roller conveyor.

Plate storing apparatuses 15, 16 according to one embodiment of the present invention are located above the case cross-feed conveyors 13, 14, respectively. With these apparatuses, a predetermined number of glass plates 10 are stored in each case 1, as described later. In this embodiment, a glass conveyance means 20 forming a part of the plate storing apparatuses 15, 16 conveys the glass plates 10, which has a size of, for example, about 1000 mm x 1000 mm, held in the upright position to the left in Fig. 4. The glass plates 10 are stored one by one in each case 1 by the plate storing apparatus 15 or 16.

In this embodiment, the glass plates 10 conveyed by the glass conveyance means 20 are inspected at an inspection station (not shown), and the glass plates 10 determined as acceptable at the inspection station are conveyed to the plate storing apparatus 15, where the acceptable glass plates 10 are stored together in one of the cases 1. On the other hand, the glass plates 10 determined as defective are conveyed to the plate storing apparatus 16 and are stored together in the other case 1.

The case 1 thus containing the predetermined number of glass plates 10 is sent out onto a case discharge conveyor 17, which is formed, for example, by a roller conveyor, by the case cross-feed conveyor 13 or 14. Then, the case 1 is conveyed by the case discharge conveyor 17 to the left in Fig. 4 and discharged from the storing system through a case discharge station 18.

Next, the plate storing apparatuses 15, 16 will be described with reference to Figs. 2 to 4. Since these plate storing apparatuses 15, 16 have the basically identical structure, a description will be given only of the plate storing apparatus 15. As shown in the figures, the plate storing apparatus 15 includes a frame 21 that is disposed to straddle the case 1 placed on the case cross-feed conveyor 13. Attached to the frame 21 are two glass-inserting hands 22 forming a part of the plate transfer means, three pairs of air chambers 23 serving as a plate holding means, and the aforementioned glass conveyance means 20.

Further attached to the frame 21 are: a pair of groove position detecting sensors 24, which are photoelectric or mechanical sensors, for example, for detecting the position of the case 1 in the arrangement direction of the grooves 1c (the transverse-directional position in Fig. 3); a pair of case feeding means 25 for precisely feeding the case in the same direction as the conveyance direction of the case 1 by the cross-feed conveyor 13, i.e., to the right in Fig. 3; and guide means 26 for positioning the glass plate 10 with respect to the feeding direction, i.e., the transverse direction in Fig. 2, by abutting the left and right ends of the glass plate 10.

The glass conveyance means 20 is formed by a number of rotatably-driven rollers 31 disposed at the upper portion of a holding member 30 extending perpendicular to the conveyance direction of the case 1 by the cross-feed conveyor 13, and the glass conveyance means 20 conveys the glass plate 10 placed in the upright position on the rollers 31 to the left in Fig. 2 with maintaining the upright position of the glass plate 10. A portion of the holding member 30 of the glass conveyance means 20 substantially corresponding to the length of the air chamber 23, i.e., the portion of the holding member 30 shown in Fig. 2, is separated from the remaining portions of the holding member 30. The separated portion of the holding member 30 is mounted on two rails 32 which extend in the direction perpendicular to the plane of Fig. 2 (the transverse direction in Fig. 3), so that the separated portion is movable along the rails 32 by a driving means (not shown).

The upper endportions of the two glass-insert ing hands 22 are fixed to a horizontal member 34 through coupling members 33. This horizontal member 34 is mounted to two vertical rails 35 so that the glass-inserting hands 22 are movable in the vertical direction. A driving means is provided, which is formed, for example, by a vertically-disposed ball screw 36, a female screw portion 37 meshing with the ball screw 36 and secured to the horizontal member 34, and a motor 38 for rotating the ball screw 36. As the motor 38 makes positive or reverse rotation, the horizontal member 34 and, in turn, the glass-inserting hands 22 move up or down.

Each glass-inserting hand 22 has a receiving finger 39 fixed to the lower end thereof. The receiving finger 39 projects rightward in Fig. 3 and receives the lower end of the glass plate 10, as described later. It should be noted that the transverse-directional positions (positions with respect to the transverse direction in Fig. 2) of the glass-inserting hands 22 are set such that each receiving finger 39 is positioned between adjacent two rollers 31 of the glass conveyance means 20. In this embodiment, the aforementioned elements 33 to 39 and the glass-inserting hands 22 form a plate transfer means.

Each air chamber 23 is formed as a long and thin rectangular box that is longer than the transverse length of the glass plate 10, and has a number of small-diameter air-jetting holes (not shown) formed in one surface. Each pair of air chambers 23 are disposed such that the surfaces having air-jetting holes face each other with a small space formed therebetween. The three pairs of air chambers are vertically spaced and fixed to the frame 21 through horizontal members 28, vertical members 29, etc. The space between the air chambers 23 of each pair is slightly greater than the thickness of the glass plate 10 to allow the glass plate 10 conveyed by the glass conveyance means 20 to be inserted into the space. The three pairs of air chambers 23 are disposed at positions where they respectively face the upper portion, the middle portion and the lower portion of the glass plate 10 stopped at the taking-out position. The lowest air chamber pair 23 is positioned slightly above the case 1 placed below.

Each air chamber 23 is connected to air piping and a compressed air source such as a blower (both of which are not shown) and jets air of equal pressure from the air jetting holes. When the glass plate 10 is placed between the three pairs of air chambers 23, air is blown against the opposite surfaces of the plate glass 10, thereby holding the glass plate 10 in the upright position with no part of the air chambers contacting the surfaces of the glass plate 10. As described later, the glass plate 10 is moved down by the glass-inserting hands 22 and is received in one of the groove pairs 1c (see Fig. 5) of the case 1. During this operation, the three pairs of air chambers 23 positioned at the three different vertical positions work to maintain the upright position of the glass plate 10 until the most part of the glass plate 10 is received in the groove pair 1c.

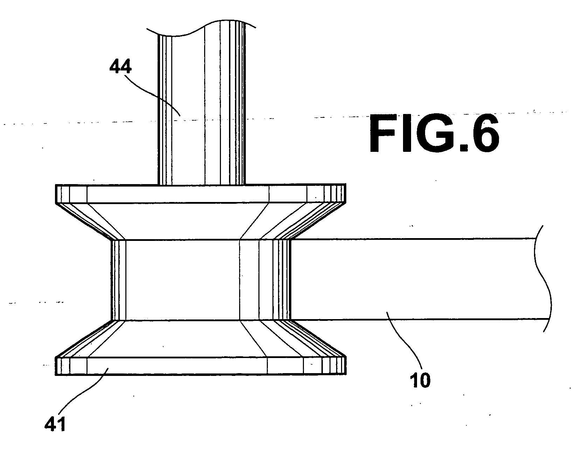

The guide means 26 is formed by: two roller-holding members 40 extending vertically and spaced apart from each other; guide rollers 41 attached to each of the roller-holding members 40 such that each roller-holding member 40 has four guide rollers 41 vertically arranged therealong; coupling members 42 coupled to each of the roller-holding members 40; and driving units 43 for moving the coupling members 42 in the vertical and transverse directions in Fig. 1. As shown in the enlarged view of Fig. 6, each guide roller 41 is formed in a substantial hourglass shape and is rotatably attached to the corresponding roller-holding member 40 through a supporting shaft 44. The driving units 43 for moving the coupling members 42 selectively set the guide rollers 41, through the coupling members 42, the roller-holding members 40 and the supporting shafts 44, to one of three positions: an engaging position (position shown in Fig. 6) where the rollers abut the side end faces of the glass plate 10 held at the taking-out position; a spaced position where the rollers are spaced apart from the side end faces of the glass plate 10 ; and a retracted position where the rollers are retracted to the right in Fig. 3 from the spaced position.

Each of the pair of case feeding means 25 is formed by a stationary block 50, a pair of rails 51 fixed to the stationary block 50 and extending in the direction in which the case 1 is fed, a moving member 52 mounted to the rails 51 and movable along the rails 51, and arms 53 attached to the moving member 52 and engageable with the case 1. In this embodiment, the case feeding means 25, the groove-position detecting sensor 24, and the cross-feed conveyor 13 form a case holding means for holding the case 1 at a predetermined position below the taking-out position where the glass plate 10 is taken out.

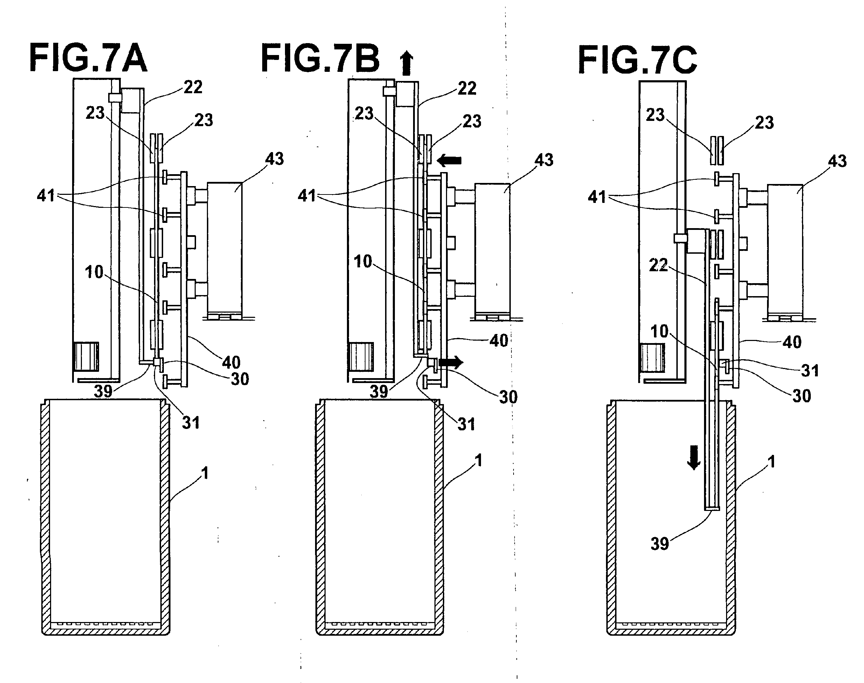

Now, a description will be given of how the glass plate 10 is stored by the plate storing apparatus 15 configured as described above. In the following description, reference is made to Figs. 7A to 7F which respectively show different states of the operating components.

An empty case 1 is first conveyed by the cross-feed conveyor 13 near a position where the case 1 receives the glass plates, and then is precisely fed by the case feeding means 25. As described later, the glass plates 10 are put in the case 1 such that the fist glass plate 10 is placed in the foremost groove pair 1c (i.e., the rightmost groove pair 1c in Fig. 3), the second glass plate 10 in the next groove pair 1c, and so on. The groove-position detecting sensor 24 detects the position of the foremost empty groove pair 1c of empty groove pairs 1c and inputs the detection signal to a control circuit (not shown). The control circuit controls driving of the case feeding means 25 based on the inputted groove-position detection signal to precisely feed the case 1 so that the foremost empty groove pair 1c is positioned just below the glass plate 10 held at the taking-out position.

The glass plate 10 to be stored in the case 1 is conveyed in the upright position by the glass conveyance means 20 and is stopped at the taking-out position shown in Fig. 2. During this stage, the guide rollers 41 are set in the retracted position so as not to interfere with the conveyance of the glass plate 10. For the same purpose, the glass-inserting hands 22 are set in a position where the receiving fingers 39 are positioned slightly lower than the top surface of the rollers 31 of the glass conveyance means 20. The glass plate 10 stopped at the taking-out position is held in the upright position by the effect of the three pairs of air chambers 32, as described previously. This state is shown in Fig. 7A.

Next, as shown in Fig. 7B, the guide rollers 41 of the guide means 26 are moved to the left in the figure to be set from the retracted position to the spaced position and further to the engaging position where the rollers 41 abut the side end faces of the glass plate 10. In this manner, the side end faces of the glass plate 10 on the conveyor rollers 31 are pressed by the guide rollers 41, whereby the glass plate 10 is positioned with respect to the conveying direction (the transverse direction of Fig. 2). Then, the glass-inserting hands 22 are moved up a predetermined distance, whereby the receiving fingers 39 contacts the lower end of the glass plate 10 and lifts the glass plate 10 from the conveyor rollers 31 of the glass conveyance means 20. Then, the holding member 30 of the glass conveyance means 20 is moved to the right in Fig. 7B to retract the conveyor rollers 31 from the position below the receiving fingers 39.

Next, as shown in Fig. 7C, the glass-inserting hands 22 are moved down to put the glass plate 10 received by the receiving fingers 39 at the lower end thereof into the case 1 from above. At this time, the case is positioned such that the foremost empty groove pair 1c is positioned just below the glass plate 10 held at the taking-out position, as describe previously, and therefore the right and left end portions of the glass plate 10 being moved down are accurately guided into the right and left grooves of the groove pair 1c. At the same time, the glass plate 10 being moved down is guided by the guide rollers 41 set in the engaging position to be positioned with respect to the depth of the grooves of the groove pair 1c. This also allows the glass plate 10 to be accurately guided into the right and left grooves of the groove pair 1c. In this manner, the glass plate 10 is prevented from colliding with areas of the case 1 around the groove pair 1c and being damaged.

Further, since the glass plate 10 is held in position by the three pairs of air chambers 23 without the surfaces thereof being contacted while it is moved down and received in the groove pair 1c, as described above, the glass plate 10 is reliably prevented from being scratched or stained. It should be noted that, although the right and left end portions of the glass plate 10 being moved down are positioned by the guide rollers 41, the guide rollers 41 contact only the right and left end faces and edges thereof of the glass plate 10, as can be seen from Fig. 6. Thus, these guide rollers 41 will make no scratch or stain on the surfaces of the glass plate 10. Of course the receiving fingers 39 of the glass-inserting hands 22 contacting the lower end face of the glass plate 10 will make no scratch or stain on the surfaces of the glass plate 10.

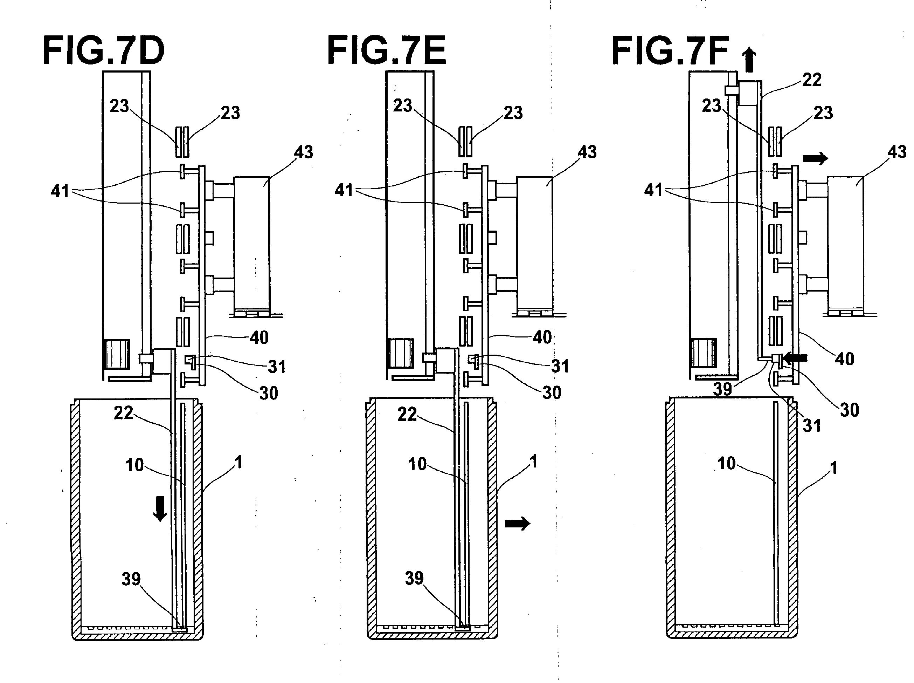

When the glass-inserting hands 22 are moved down to a predetermined lowest position, as shown in Fig. 7D, the receiving fingers 39 enter the grooves le (see Fig. 5) formed in the bottom plate 1d of the case 1, while the glass plate 10 is received at its lower end face by the bottom plate 1d and is separated from the receiving fingers 39.

As shown in the Fig. 7E, once the glass plate 10 is thus transferred into the case 1, the case feeding means 25 advances the case 1 (to the right in Fig. 7E) by a distance equal to the pitch of the grooves 1c. At this time, the case feeding means 25, which is controlled based on the groove-position detection signal outputted by the groove-position detecting sensor 24, as described above, positions the case 1 so that the foremost empty groove pair 1c, in which the next glass plate 10 is received, is positioned just below the glass taking-out position. Thus, the empty groove pair 1c to receive the next glass plate 10 is set in a fixed relative position with respect to the glass-inserting hands 22.

Next, as shown in Fig. 7F, the glass-inserting hands 22 are moved up, the guide rollers 41 are returned from the engaging position through the separated position to the retracted position, and the holding member 30 of the glass conveyance means 20 is moved to the left in Fig. 7F to return the conveyor rollers 31 to the position where they can receive the glass plate 10 and convey it. In this manner, the respective components are returned to the state shown in Fig. 7A. Subsequently, another glass plate 10 is conveyed by the glass conveyance means 20, and the glass plate 10 stopped at the glass taking-out position is stored in the case 1 as described above.

The same operations as described above are repeated. Once a predetermined number of glass plates 10 are stored in the case 1, the case 1 is sent out by the cross-feed conveyor 13 onto the case discharge conveyor 17 shown in Fig. 4. Thereafter, a new empty case 1 is supplied to the plate storing apparatus 15 by the case supply conveyor 12 and the cross-feed conveyor 13 shown in Fig. 4, and the predetermined number of glass plates 10 are stored in the case 1 in the same manner.

As has been described above, in the plate storing apparatus 15, the glass-inserting hands 22 are moved down to put the glass plate 10 in the case 1 from above. Therefore, the glass plate 10 can be stored in the case 1 in a shorter cycle time than conventional apparatuses in which the glass plate 10 is moved sideways by a large amount to be put in the case by a pivoting robot hand.

In addition, since the plate storing apparatus 15 does not move the glass plate 10 sideways by a large amount to put it in the case 1, the mechanism thereof is simple and it is not necessary to position the case supply conveyor 12 and other components so as not to interfere with such a robot hand that moves sideways. Therefore, the space required for placing the plate storing apparatus 15, the case supply conveyor 12 and other components is relatively small.

In particular, in the plate storing apparatus of this embodiment, the plate transfer means has a simple structure which only moves the glass-inserting hands 22 up or down. Therefore, the plate storing apparatus can be formed relatively inexpensively when compared with the conventional plate storing apparatuses that use, as the plate transfer means, a robot hand or the like that is designed to make complex movements.

## Claims

1. A method for storing plates in a case by supplying the plates one by one to the case, the case having pairs of vertical grooves formed in inner surfaces of right and left side plates thereof, the plates being stored in the case in the upright position with right and left end portions of each plate placed in one of the groove pairs, the method comprising the steps of:
conveying each plate held in the upright position to a predetermined taking-out position;
placing the case below the taking-out position;
receiving and holding a lower end face of the plate positioned at the taking-out position and moving the plate down from the taking-out position into one of the groove pairs of the case; and
holding the plate in the upright position by blowing gas against opposite surfaces of the plate without contacting thereto at least while the plate is moved from the taking-out position and received in the groove pair of the case.

2. An apparatus for storing plates in a case by supplying the plates one by one to the case, the case having pairs of vertical grooves formed in inner surfaces of right and left side plates thereof, the plates being stored in the case in the upright position with right and left end portions of each plate placed in one of the groove pairs, the apparatus comprising:
conveyance means for conveying each plate held in the upright position to a predetermined taking-out position;
case holding means for holding the case below the taking-out position;
plate transfer means having receiving members for receiving a lower end face of the plate from below, the plate transfer means holding the plate positioned at the taking-out position on the receiving members and moving the plate down from the taking-out position into one of the groove pairs of the case; and
plate holding means for holding the plate in the upright position by blowing gas against opposite surfaces of the plate without contacting thereto at least while the plate is moved from the taking-out position and received in the groove pair of the case.

3. The apparatus as set forth in claim 2, further comprising:
a sensor for detecting the position of the next one of the groove pairs of the case to receive the next plate; and
means for finely adjusting the position of the case based on a groove position detection signal outputted by the sensor to set the next groove pair in a fixed relative position with respect to the plate transfer means.

4. The apparatus as set forth in claim 2 or 3, further comprising:
guide means for positioning right and left end faces of the plate being moved down by the plate transfer means at a position above the next groove pair and guiding the right and left end portions of the plate toward the next groove pair.

5. The apparatus as set forth in any one of claims 2 to 4, wherein
the plate transfer means is movable only in the vertical direction, and
the conveyance means is retracted sideways when the plate has been lifted by the receiving members of the moved-up plate transfer means and separated from the conveyance means, to avoid interference with the plate being moved down.

6. The apparatus as set forth in any one of claims 2 to 5, wherein
the plate transfer means is movable only in the vertical direction, and
each time one plate has been stored in the case, the case holding means moves the case, having the pairs of right and left grooves arranged at a predetermined pitch, by a distance approximately equal to the pitch in a direction of arrangement of the groove pairs to set the next groove pair for receiving the next plate in a fixed relative position with respect to the plate transfer means.
